# DEMANDE DE BREVET EUROPEEN

(11) **EP 2 330 745 A1**
(43) Date de publication de la demande: **08.06.2011**
(21) Numéro de dépôt: 10189080.4
(22) Date de dépôt: 27.10.2010
(51) Int. Cl.: H03M 13/11, H03M 13/41, G11B 20/18

(54) **Procédé et dispositif de décodage d'une succession de blocs encodés avec un code de correction d'erreur et corrélés par un canal de transmission**

(30) Priorité: 29.10.2009 FR 0957624
(71) Demandeur: STMicroelectronics SA, 92120 Montrouge (FR)
(72) Inventeur: Heinrich, Vincent, 38140 Izeaux (FR); Urard, Pascal, 38570 Theys (FR)
(74) Mandataire: Zapalowicz, Francis

(57) **Abrégé**

Procédé de décodage d'un bloc de N informations encodées avec un code de correction d'erreur et mutuellement corrélées.

Le procédé comprend les étapes suivantes :
a) on réalise une première décorrélation des N informations d'un bloc ;
b) on mémorise le bloc ainsi décorrélé ;
c) on effectue un traitement de décodage d'un groupe de P informations dudit bloc ;
d) on décorrèle au moins une partie des P informations décodées ;
e) on réitère les étapes c) à d) avec des groupes successifs différents de P informations dudit bloc jusqu'à traiter les N informations dudit bloc ;
f) on réitère l'étape e) jusqu'à la satisfaction d'un critère de décodage.

## Description

### Procédé de décodage d'une succession de blocs encodés avec un code de correction d'erreur et corrélés par un canal de transmission.

L'invention concerne le décodage de canal et plus particulièrement le décodage de blocs d'informations préalablement encodés à l'aide d'un code de correction d'erreur ayant subi des interférences lors de leur transmission via un canal de transmission dans un système de communication. L'invention concerne notamment mais non exclusivement le décodage d'un signal transmis dans un disque dur entre une chaîne d'écriture et une chaîne de lecture.

Dans le module de codage de canal d'une chaîne de communication, un code de correction d'erreur, par exemple un code LDPC (« Low Density Parity Check »), peut être utilisé pour améliorer la qualité de transmission du signal. En général, le bruit généré par le canal de transmission d'un système de communication est de type gaussien. Dans le cas de systèmes d'enregistrement magnétique, tels que des disques durs, le canal de transmission magnétique délivre des blocs d'informations bruités avec un grand facteur de corrélation. Ce grand facteur de corrélation est principalement dû aux interférences causées par la proximité physique entre les informations inscrites sur le disque dur, et la vitesse de lecture des données. Ces interférences ont pour conséquence de rendre les informations dépendantes des informations précédentes ; c'est pourquoi on parle d'informations corrélées.

Le bruit généré par le canal de transmission peut être modélisé à partir de filtres à réponses impulsionnelles finies (FIR) par un encodeur à convolution. A la réception, on effectue des opérations de décodage du canal. De part la connaissance du bruit généré par le canal de transmission, il est possible de décorréler les informations à l'aide de moyens de décorrélation. Cette décorrélation qui peut être effectuée avec un algorithme classique du type VITERBI, fait partie du décodage de canal.

De plus, le décodage de canal comporte un décodage des blocs encodés avec le code de correction d'erreur pour recouvrer les symboles inscrits sur le disque.

Comme indiqué ci-avant, un exemple de code de correction d'erreur est un code à base de blocs comme par exemple les codes à base de blocs dont la matrice de parité présente une faible densité, c'est-à-dire, comporte un faible nombre de 1. De tels codes sont plus connus de l'homme du métier sous la dénomination « codes LDPC » (« Low Density Parity Check »).

Le code LDPC, étant un code à base de blocs, l'encodeur traite des blocs de K bits et délivre des blocs de N bits. Ainsi, N-K bits de redondance sont ajoutés. Ces N-K bits sont appelés « bits de parité ».

Le taux de codage (« Code rate », en langue anglaise) est défini par le rapport K/N. Plus le taux de codage est bas, plus le nombre de bits de redondance est élevé et ainsi plus grande est la protection contre le bruit du canal de transmission.

Ces N-K bits sont calculés à l'aide d'une matrice de parité H. Cette matrice a N-K lignes et N colonnes et est composée de « 1 » et de « 0 » avec un nombre de « 1 » faible par rapport au nombre de « 0 ». C'est la raison pour laquelle ce type de codes basés sur une telle matrice sont dénommés « codes LDPC », c'est-à-dire des codes à faible densité.

Le bloc encodé C, de N bits, est calculé en résolvant l'équation H. C^{T} = 0, où H désigne la matrice de parité, et T la fonction « transposée ».

Du côté du décodeur, la correction des bits erronés est effectuée à partir des relations entre les informations codées du bloc. Ces relations sont données par la matrice de parité H. Le décodeur utilise des métriques internes correspondant aux « 1 » de la matrice H. La matrice H correspond au graphe de Tanner du code LDPC comportant des noeuds dits de contrôle (« check nodes ») et des noeuds d'information (« bit nodes ») reliés entre eux par le chemin des graphes représentatifs des messages échangés itérativement entre les noeuds ainsi reliés. Ces métriques sont mises à jour par lignes (mise à jour des noeuds de contrôle) en prenant en compte les métriques internes d'une même ligne. Ensuite, le décodeur met à jour ces métriques par colonnes (mise à jour des noeuds d'information) en prenant en compte les métriques internes sur une même colonne ainsi que l'information correspondante en entrée du décodeur et provenant du canal de transmission. Une itération correspond à la mise à jour des noeuds de contrôle pour toutes les métriques internes suivie de la mise à jour des noeuds d'information pour toutes les métriques internes.

Le décodage d'un bloc nécessite plusieurs itérations.

Les valeurs des bits décodés, également appelées « décisions dures » (« Hard decisions », en langue anglaise) sont obtenues en additionnant les métriques internes par colonnes avec les informations reçues et en prenant le signe du résultat. Ce résultat est encore désigné sous le vocable de « décision douce » (soft décision) ou « LLR » (Log Likelyhood Ratio). Le signe du résultat fournit la valeur « 0 » ou « 1 » du bit (« décision dure ») tandis que la valeur absolue du résultat donne une indication de confiance (probabilité) pour cette valeur logique « 0 » ou « 1 ».

Les codes du types LDPC sont intéressants car ils permettent d'obtenir un taux d'erreurs de bits (BER : « Bit Error Rate », en langue anglaise) très bas, en raison du caractère itératif de l'algorithme de décodage. Plusieurs algorithmes itératifs de décodage existent pour décoder des codes LDPC. On pourra notamment citer l'algorithme classique dit «à propagation de croyance » et bien connu de l'homme du métier sous la dénomination anglo-saxonne « Belief Propagation » (BP).

La durée de décodage d'un bloc est directement liée au nombre d'itérations requis. Ainsi, pour atteindre un débit donné, un nombre d'itérations maximum est défini pour chaque taux de codage et chaque bloc pourra être décodé avec ce nombre maximum d'itérations. Par exemple, le nombre maximum d'itérations peut être fixé à 50. Cela étant, si le décodage n'a pas convergé au bout de ces 50 itérations, alors, il en résulte une diminution des performances de décodage.

Comme indiqué ci-avant, la décorrélation des informations d'un bloc peut s'effectuer à l'aide de moyens de décorrélation tel qu'un décodeur de Viterbi. Ce décodeur basé sur un algorithme de Viterbi permet de décoder un bloc d'informations codé à partir d'une correction d'erreur basée sur un code à convolution.

Il est possible d'utiliser un décodeur SOVA (Soft Output Viterbi Algorithm) qui est une variante de l'algorithme classique de Viterbi qui est généralement implémentée comme un algorithme à deux étapes, avec une partie d'algorithme de Viterbi et une partie s'occupant de calculer les probabilités (soft-output). La première étape d'un SOVA est de sélectionner la séquence la plus probable permettant de passer par un seul noeud d'un treillis à chaque instant. Chaque noeud possédant au moins deux branches convergeant sur le noeud, une d'entre elles étant choisie dans ladite séquence, la différence entre la valeur portée sur chaque branche indique le taux d'erreur de chaque choix. La valeur ainsi portée sur chaque branche, également appelée métrique de branche, est accumulée durant tous les calculs pour indiquer la probabilité de confiance de la valeur du bit décodé (décision dure).

Dans un cas général où un décodeur SOVA et un décodeur LDPC sont utilisés pour effectuer le décodage de canal, on peut réaliser quelques itérations externes correspondant à une itération de boucle « décodeur SOVA - décodeur LDPC » et environ 8 itération de décodeur LDPC pour chaque itération externe pour obtenir une capacité de correction satisfaisante.

Par ailleurs, les disques requièrent un débit de transmission élevé, de l'ordre de 4Gbit/s. Afin d'obtenir un tel débit, une solution connue consiste à dérouler la boucle externe en réalisant un couplage en série de plusieurs décodeurs SOVA et de plusieurs décodeurs LDPC.

Les décodeurs étant conçus sur un modèle de canal imparfait, il est nécessaire d'augmenter le nombre d'itérations externes pour améliorer la qualité du décodage. Les corrections apportées par un type de décodeur permettent en effet d'améliorer la correction effectuée par l'autre type de décodeur. Pour cela, une des solutions consiste à augmenter le nombre de décodeurs SOVA et de décodeurs LDPC. Sinon il faut diminuer le débit de transmission.

Par ailleurs, il a été remarqué qu'il est préférable d'avoir un nombre plus important d'itérations externes même si le nombre d'itérations LDPC est diminué en conséquence.

Selon un mode de mise en oeuvre et de réalisation, il est proposé de coupler des moyens de décorrélation, tels que des décodeurs SOVA, et des moyens de décodage de code de correction d'erreur, tels qu'un décodeur LDPC, de manière à réaliser un décodage LDPC d'un groupe d'informations d'un bloc suivi d'une décorrélation à l'aide d'une pluralité de décodeurs SOVA d'au moins une partie des données ainsi décodées avant de réaliser un décodage LDPC d'un nouveau groupe d'informations du même bloc. Ce nouveau décodeur ainsi réalisé par une fusion d'un décodeur LDPC avec une pluralité de décodeurs SOVA en parallèle permet d'augmenter le nombre d'itérations assimilées à des itérations externes étant donné que le nouveau décodeur peut être considéré comme un unique décodeur LDPC dont les informations de canal sont mises à jour pendant le décodage LDPC, permettant ainsi d'augmenter les performances de décodage tout en conservant une surface d'occupation plus petite que dans le cas d'une utilisation de plusieurs décodeurs LDPC et plusieurs décodeurs SOVA.

Selon un aspect, il est ainsi proposé un procédé de décodage d'un bloc de N informations encodées avec un code de correction d'erreur et mutuellement corrélées.

Le procédé comprend les étapes suivantes :
a) on réalise une première décorrélation des N informations du bloc ;
b) on mémorise le bloc ainsi décorrélé ;
c) on effectue un traitement de décodage d'un groupe de P informations dudit bloc ;
d) on décorrèle au moins une partie des P informations décodées ;
e) on réitère les étapes c) et d) avec des groupes successifs différents de P informations dudit bloc jusqu'à traiter les N informations dudit bloc ;
f) on réitère l'étape e) jusqu'à la satisfaction d'un critère de décodage.

Au cours d'une itération, le fait de pouvoir décorréler les informations qui ont déjà été décodées, c'est-à-dire d'avoir un ordre de décodage des informations identique à l'ordre de décorrélation des informations résulte en particulier d'un entrelacement initial des informations du bloc. En d'autre termes, les informations reçues sont alors déjà entrelacées pour permettre la succession des étapes c) et d).

De préférence, le code de correction d'erreur comporte des noeuds de contrôle et des noeuds d'informations reliés selon une connectivité définie, le groupe de P informations comporte des informations relatives à au moins un noeud de contrôle et aux noeuds d'information connectés à ce noeud de contrôle, et le traitement de décodage effectué à l'étape c) comporte une mise à jour du noeud de contrôle et des noeuds d'informations qui lui sont connectées.

On peut avantageusement décorréler à l'étape d) toutes les P informations décodées du groupe.

Le nombre minimal d'informations d'un groupe de P informations est égal au degré de contrôle du code de correction d'erreur correspondant au nombre de noeuds d'informations auquel est relié un noeud de contrôle.

Le degré de contrôle du code de correction d'erreur correspond au nombre de noeuds d'information auquel est relié un noeud de contrôle.

Préférentiellement, le code de correction d'erreur est un code du type LDPC.

De préférence, on décorrèle les informations à l'aide d'un algorithme de Viterbi de type SOVA.

Selon un autre aspect de l'invention, il est proposé, dans un mode de réalisation, un dispositif de décodage comprenant une entrée pour recevoir un bloc de N informations encodés avec un code de correction d'erreur et mutuellement corrélées, des moyens de décorrélation aptes à décorréler ledit bloc, des moyens de mémoire aptes à mémoriser ledit bloc, et des moyens de décodage du code de correction d'erreur aptes à décoder ledit bloc de façon itérative.

Le décodeur comprend en outre :
- des moyens de commande aptes à activer les moyens de décorrélation pour réaliser une première décorrélation des N informations du bloc, à activer les moyens de mémorisation pour mémoriser le bloc ainsi décorrélé, à activer les moyens de décodage pour effectuer un traitement de décodage d'un groupe de P informations dudit bloc, puis à activer les moyens de décorrélation pour décorréler au moins une partie des P informations décodées, et à répéter ces activations avec des groupes successifs différents de P informations dudit bloc jusqu'à traiter les N informations du bloc, et
- des moyens de gestion aptes à activer les moyens de commandes jusqu'à la satisfaction d'un critère de décodage.

De préférence, le code de correction d'erreur comporte des noeuds de contrôle et des noeuds d'informations reliés selon une connectivité définie, le groupe de P informations comporte des informations relatives à au moins un noeud de contrôle et aux noeuds d'information connectés à ce noeud de contrôle, et le dispositif de décodage est apte à effectuer une mise à jour dudit au moins un noeud de contrôle et des noeuds d'informations qui lui sont connectés.

Avantageusement, les moyens de décorrélation peuvent comprendre une pluralité de modules de décorrélation couplés parallèlement les uns aux autres, le nombre de modules de décorrélation correspondant au plus à un nombre de P informations comprises dans un groupe d'un bloc.

De préférence, les moyens de décodage du code de correction d'erreur forment des moyens de décodage de code LDPC.

Un groupe de P informations peut avantageusement comprendre un nombre d'informations au moins égal au degré de contrôle du code de correction d'erreur.

Les modules de décorrélation forment préférentiellement des moyens de décodage de canal à algorithme de Viterbi de type SOVA.

Selon un autre aspect, il est avantageusement proposé un récepteur d'un système de communication comprenant un dispositif de décodage tel que décrit ci-dessus.

Selon un autre aspect, il est proposé un système de communication comprenant un transmetteur comprenant des moyens d'encodage des informations avec un code de correction d'erreur, un récepteur tel que décrit ci-dessus, et un canal de transmission.

De préférence, le système de communication est un système d'enregistrement magnétique tel qu'un disque dur.

D'autres avantages et caractéristiques de l'invention apparaîtront à l'examen de la description détaillée de modes de réalisation et de mise en oeuvre, nullement limitatifs, et des dessins annexés sur lesquels :
- la figure 1 illustre schématiquement un exemple de structure interne d'un système de communication selon l'art antérieur,
- la figure 2 illustre plus en détail, mais toujours schématiquement, un décodeur de canal selon l'art antérieur,
- la figure 3 est un organigramme représentatif d'un procédé de décodage de canal selon l'art antérieur,
- les figures 4a et 4b illustrent plus en détail, mais toujours schématiquement, un mode de réalisation d'un système de communication et un mode de réalisation d'un décodeur selon l'invention,
- la figure 5 est un organigramme représentatif d'un mode de mise en oeuvre d'un procédé de décodage selon l'invention,
- la figure 6 est une courbe montrant des avantages de l'invention ;
- la figure 7 présente un exemple de graphe de Tanner.

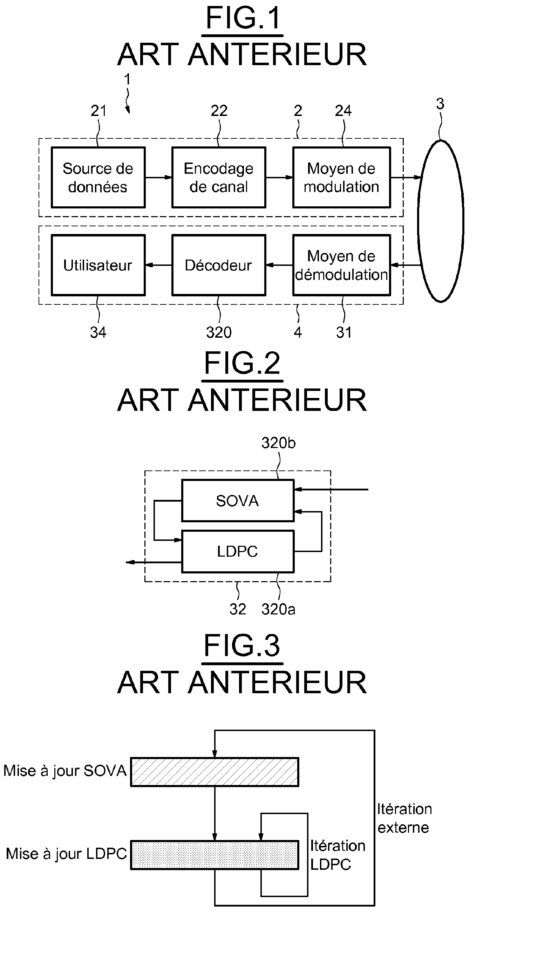

Sur la figure 1 a été représenté de manière schématique un système de communication 1 tel qu'un disque dur.

Le système de communication 1 comprend une chaîne de transmission 2, telle qu'une chaîne d'écriture d'un disque dur, capable de transmettre sur un canal de transmission 3 des informations codées et modulées.

Par ailleurs, ce système de communication 1 comporte également une chaîne de réception 4, telle qu'une chaîne de lecture d'un disque dur, capable de recevoir et de décoder des informations en provenance du canal de transmission 3.

La chaîne de transmission 2 comporte de façon classique et connue en soi une source d'informations 21 aptes à générer une succession de blocs d'informations destinés à être transmis, et pouvant comprendre des moyens de compression d'informations aptes à augmenter le débit d'informations.

La chaîne de transmission 2 comporte également des moyens d'encodage de canal 22 dont la fonction est notamment d'ajouter de la redondance pour pouvoir par la suite corriger les erreurs potentielles en réception dues au bruit du canal de transmission. Ces moyens d'encodage de canal 22 comportent par exemple des moyens de codage LDPC.

Enfin la chaîne de transmission 2 comprend des moyens de modulation 24, tels qu'une tête d'écriture d'un disque dur, aptes à adapter le signal au canal de transmission 3.

La chaîne de réception 4 comporte des moyens homologues effectuant les fonctions inverses. Plus précisément, on trouve, tout d'abord, des moyens de démodulation 31 tels qu'une tête de lecture d'un disque dur.

Les informations sont ensuite délivrées à des moyens de décodage de canal 320 permettant de décoder les blocs d'informations préalablement encodés avec le code de correction d'erreur et ayant subi d'éventuelles perturbations lors de la transmission via le canal de transmission 3. Les informations ainsi décodées sont finalement délivrées à un utilisateur d'informations 34 pouvant comporter des moyens de décompression permettant de décompresser les informations éventuellement compressées.

Dans l'art antérieur illustré sur la figure 2, il est connu de former des moyens de décodage de canal 320 en couplant des moyens de décodage du code de correction d'erreur tels qu'un décodeur LDPC 320a avec des moyens de décorrélation tels qu'un décodeur SOVA 320b. Le couplage est réalisé de manière à former une boucle.

La figure 3 représente un organigramme représentatif du procédé de décodage utilisé dans l'art antérieur. Classiquement, le décodeur SOVA 320b réalise tout d'abord une mise à jour (décodage de type VITERBI) de toutes les informations d'un bloc. Le bloc est ensuite transmis au décodeur LDPC 320a qui effectue un décodage LDPC de toutes les informations du bloc délivré par le décodeur SOVA durant plusieurs itérations (en général 8 itérations) nommées itérations LDPC. Une fois la pluralité d'itérations LDPC réalisée, les informations ainsi mises à jour (décodées) en sortie du décodeur LDPC 320a sont ensuite renvoyées lors d'une itération externe dans le décodeur SOVA 320b pour une nouvelle mise à jour SOVA (nouveau décodage). Le bouclage est ainsi réalisé jusqu'à ce qu'un mot de code soit décodé. Le décodage d'un mot de code est détecté à partir d'un procédé de contrôle classique et non décrit, ou bien le mot de code peut être considéré comme décodé après qu'un nombre d'itérations externes donné a été réalisé.

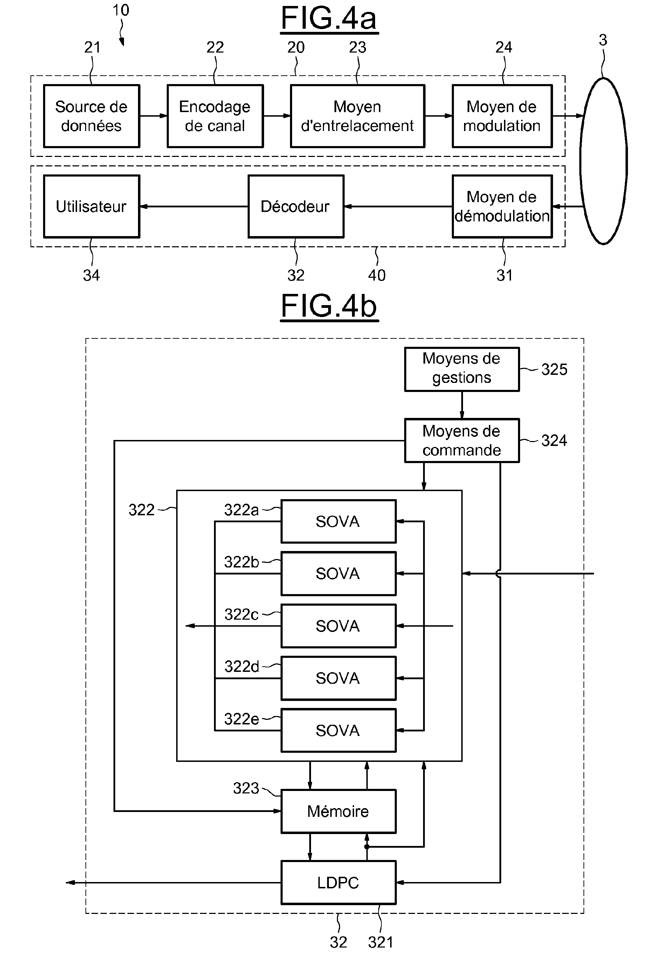

Sur la figure 4a a été représenté de manière schématique un système de communication 10 selon l'invention. Les éléments identiques à ceux de la figure 1 portent les mêmes références.

Ainsi, le système de communication 10 comprend une chaîne de transmission 20, telle qu'une chaîne d'écriture d'un disque dur, capable de transmettre sur un canal de transmission 3 des informations codées et modulées, ainsi qu'une chaîne de réception 40, telle qu'une chaîne de lecture d'un disque dur, capable de recevoir et de décoder des informations en provenance du canal de transmission 3.

En sortie des moyens d'encodage de canal 22, la chaîne de transmission 20 comporte également des moyens d'entrelacement 23 aptes à arranger l'ordre des informations dans le bloc selon un ordre souhaité.

Les moyens d'entrelacement 23 permettent, en outre, de protéger les données d'erreurs ponctuelles dans le canal de transmission 3. Les erreurs ponctuelles peuvent recouvrir plusieurs données adjacentes. En ordonnant les données pour le transfert via le canal de transmission 3 selon un ordre donné permettant de ne pas avoir deux données initialement adjacentes côte à côte, les erreurs ponctuelles ne peuvent pas toucher un groupe de données adjacentes dans l'ordre initial. Ainsi, en disposant les données à nouveau selon l'ordre initial lors du décodage, les erreurs n'ont pas touchées plusieurs données adjacentes, créant ainsi moins de problèmes de décodage.

En lieu et place du décodeur 320, la chaîne de réception 40 comprend des moyens de décodage de canal 32 selon l'invention.

La figure 4b représente de manière schématique un mode de réalisation de moyens de décodage 32, ou décodeur, selon l'invention.

Dans ce mode de réalisation, le décodeur 32 (décodeur de canal) comprend, tout d'abord, des moyens de décodage de code de correction d'erreur qui sont, dans cet exemple, un décodeur LDPC 321. Le décodeur 32 comprend, de plus, des moyens de décorrélation 322 qui comprennent une pluralité de modules de décorrélation tels que des décodeurs SOVA 322a à 322e. Dans cet exemple, cinq décodeurs SOVA 322a à 322e ont été représentés de manière non limitative.

Les décodeurs SOVA 322a à 322e des moyens de décorrélation 322 sont couplés ensemble en parallèle de manière à travailler simultanément, chacun sur une partie des informations d'un bloc de N informations.

Le décodeur 32 reçoit en entrée un bloc de N informations qui est injecté aux moyens de décorrélation 322. Des moyens de mémorisation 323 permettant de stocker successivement et temporairement les blocs d'informations sont couplés, tout d'abord, entre la sortie des moyens de décorrélation 322 et l'entrée du décodeur LDPC 321, et d'autre part, entre la sortie du décodeur LDPC 321 et l'entrée des moyens de décorrélation 322. Le décodeur LDPC 321 comprend également un couplage direct aux moyens de décorrélation 322 permettant de transmettre un certain nombre d'informations sans temporisation due aux moyens de mémorisation 323.

Le décodeur LDPC 321 comprend également une autre sortie permettant de délivrer en sortie du décodeur 32 les blocs décodés.

Les moyens de mémorisation peuvent comprendre un deux modules de mémorisation distincts, un premier module couplé entre les moyens de décorrélation 322 et le décodeur LDPC 321, et un second module couplé entre le décodeur LDPC 321 et les moyens de décorrélation 322.

Les moyens de mémorisation 323 permettent de mémoriser les informations suivantes traitées par le décodeur LDPC 321, par exemple, alors que les moyens de décorrélation 322 n'ont pas eu le temps de mettre à jour les informations précédemment traitées par le décodeur LDPC 321. Ils permettent également de mémoriser les informations suivantes traitées par les moyens de décorrélation 322, par exemple, alors que le décodeur LDPC 321 n'a pas eu le temps de traiter les informations précédemment mises à jour par les moyens de décorrélation 322.

Enfin le décodeur 32 comprend des moyens de commande 324 aptes à commander les moyens de décorrélation 322, les moyens de mémorisation 323 et les moyens de décodage de code de correction d'erreur 321, et des moyens de gestions 325 permettant de commander les moyens de commande 324.

Les moyens de commande 324 permettent notamment d'adresser la mémoire pour permettre d'effectuer le réordonnancement des données explicité ci-avant.

Les moyens de commande 324 permettent également d'activer les moyens de décorrélation 322 pour réaliser une première décorrélation des N informations du bloc, d'activer les moyens de mémorisation 323 pour mémoriser le bloc décorrélé, d'activer les moyens de décodage 321 pour le traitement de décodage d'un groupe de P informations dudit bloc, puis d'activer les moyens de décorrélation 322 pour décorréler au moins une partie des P informations décodées, et de répéter les commandes avec des groupes successifs différents de P informations dudit bloc jusqu'à traiter les N informations.

Les moyens de gestion 325 permettent de réitérer la commande des moyens de commandes 324 jusqu'à la satisfaction d'un critère de décodage.

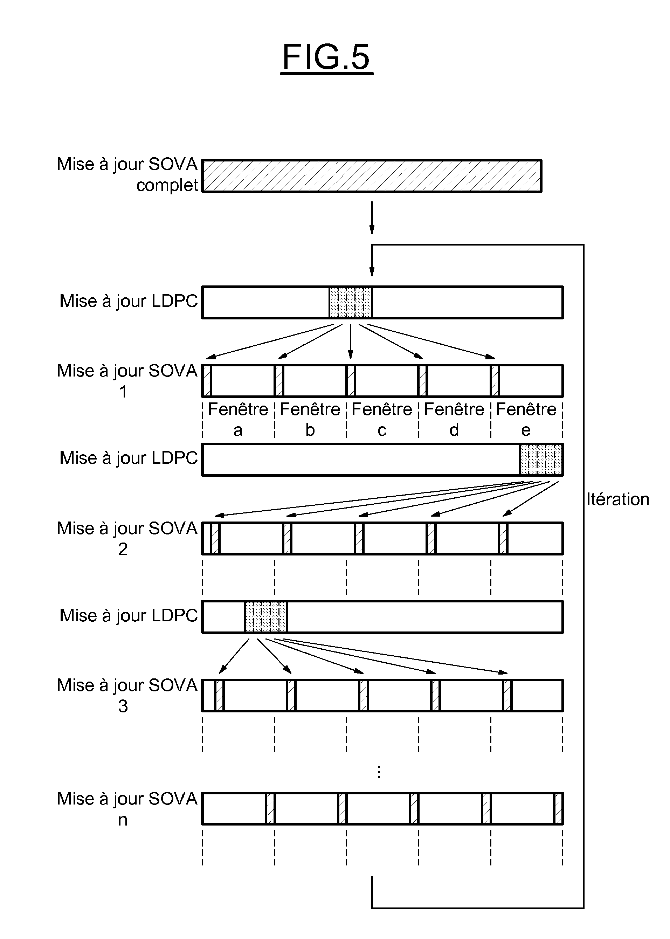

La figure 5 est un organigramme représentatif d'un mode de mise en oeuvre d'un procédé de décodage selon l'invention qui permettra de comprendre le fonctionnement du décodeur 32 décrit sur la figure 4.

Dans une première étape du mode de mise en oeuvre du procédé de décodage, les moyens de décorrélation 322 réalisent une mise à jour complète des N informations comprises dans un bloc reçu en entrée du décodeur 32. Cette mise à jour SOVA complète est réalisée par les décodeurs SOVA 322a à 322e qui travaillent chacun sur une fenêtre du bloc d'information équivalente.

En effet, la mise en parallèle de décodeurs SOVA permet de traiter simultanément des informations. Pour optimiser ainsi la mise à jour SOVA, le bloc d'informations est divisé en fenêtres de travail de tailles égales. Dans cet exemple, chacun des cinq décodeurs SOVA 322a à 322e traite les informations d'une fenêtre de travail *Fenêtre a* à *Fenêtre e* comprenant 1/5^{e} des N informations.

Un décodeur SOVA traite consécutivement les informations dans l'ordre où elles se trouvent. Aussi, les décodeurs SOVA 322a à 322e décodent la première information de leur fenêtre de travail, puis les informations suivantes jusqu'à la dernière de leur fenêtre de travail.

Une fois la mise à jour SOVA complète réalisée en parallèle par les cinq décodeurs SOVA 322a à 322e des moyens de décorrolation 322, les informations qui ont ainsi été une première fois décorrélées sont délivrées au décodeur LDPC 321 via les moyens de mémorisation 323 qui permettent de garder en mémoire les informations mises à jour par les moyens de décorrélation 322 le temps que le décodeur LDPC 321 traites les informations précédentes.

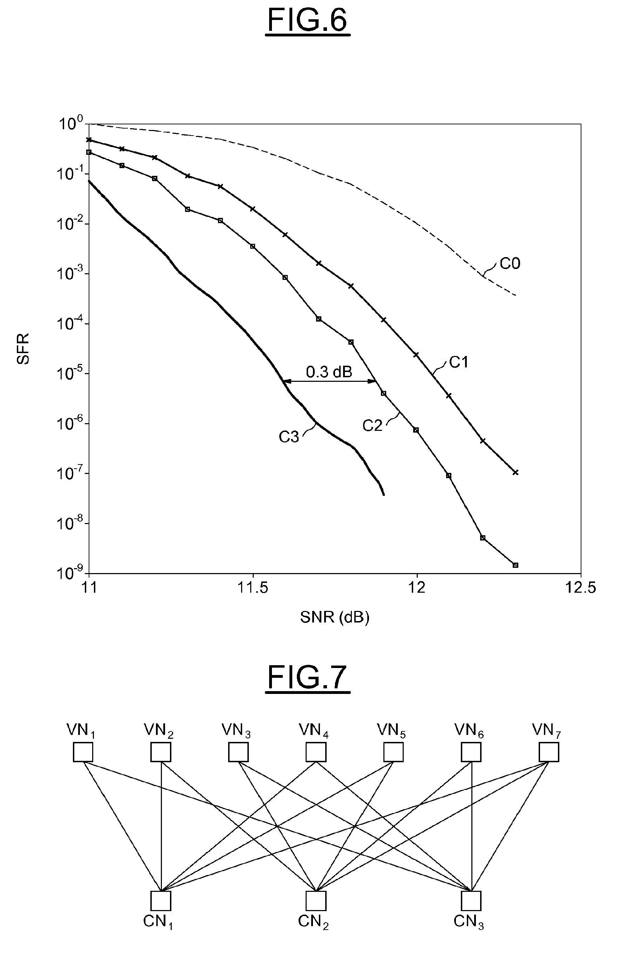

Contrairement aux décodeurs SOVA 322a à 322e qui traitent les informations de manière linéaire, le décodeur LDPC 321 traite les informations d'une manière non linéaire selon un schéma connu (également appelé graphe de Tanner) dont un exemple est représenté sur la figure 7. Le graphe du code de correction d'erreur comporte des noeuds de contrôle CN (« Check Nodes ») et des noeuds d'informations VN « Variable Nodes » ou « Information Nodes ») reliés selon une connectivité définie. Un groupe de P informations comporte ainsi des informations relatives à au moins un noeud de contrôle CN et aux noeuds d'information VN connectés à ce noeud de contrôle CN.

Les informations d'un bloc ne sont pas organisées de la même manière à leur réception par un décodeur SOVA, qui traite les informations de manière linéaire sans modifier leur organisation à leur réception, ou par un décodeur LDPC.

Un décodeur LDPC organise les informations sous forme de matrice comportant N colonnes et un nombre de lignes égale au nombre de redondances comprises dans les N informations du bloc. Ce nombre de redondances équivaut au nombre de noeuds de contrôle (« check nodes ») du graphe de Tanner. Chaque ligne de la matrice correspond donc à un noeud de contrôle du code LDPC. Ainsi à chaque mise à jour LDPC, un ou plusieurs noeuds de contrôle sont mis à jour. On traite donc une ou plusieurs lignes de la matrice par mise à jour LDPC.

Lors d'une mise à jour d'un ou plusieurs noeuds de contrôle, cette mise à jour permet de traiter un nombre P d'informations d'un groupe. A la suite de la mise à jour d'un ou plusieurs noeuds de contrôle, les noeuds d'informations (« information nodes » ou « variable nodes ») du graphe de Tanner, couplés à ces noeuds de contrôle, sont partiellement mis à jour à partir des informations des noeuds de contrôle. Chaque noeud d'information est couplé à plusieurs noeuds de contrôle. C'est pourquoi, à la suite d'une mise à jour d'un noeud de contrôle, la mise à jour d'un noeud d'information n'est que partielle.

L'entrelacement réalisé dans le transmetteur 20 par les moyens d'entrelacement 23 permet d'ordonner les informations de manière qu'au moins une partie des P informations décodées de la première ligne de la matrice traitée lors de la mise à jour LDPC, correspondent à la première information de chaque fenêtre traitée lors de la première mise à jour partielle SOVA. Au cours d'une itération, le fait de pouvoir décorréler les informations qui ont déjà été décodées, c'est-à-dire d'avoir un ordre de décodage des informations identique à l'ordre de décorrélation des informations, résulte en particulier de l'entrelacement initial des informations du bloc. En d'autre termes, les informations reçues sont alors déjà entrelacées pour permettre les décodages et les décorrélations successifs.

L'homme du métier saura paramétrer cet entrelaceur 23 pour obtenir l'ordre désiré compte tenu de la connaissance de l'ordre de traitement des informations du décodeur LDPC 321.

Ainsi comme indiqué sur la figure 4b, le décodeur LDPC 321 reçoit le bloc de N informations mis à jour par les moyens de décorrélation 322, et décode un premier groupe de P informations du bloc. Le nombre P d'informations comprises dans un groupe du bloc est plus petit que le nombre N d'informations contenues dans un bloc et est au moins égal au nombre de décodeurs SOVA compris dans les moyens de décorrélation 322.

Dans cet exemple, le décodeur LDPC 321 décode par groupe de P=5 informations. Les cinq informations décodées du premier groupe correspondent à la première information de chacune des cinq fenêtres de travail *Fenêtre a* à *Fenêtre e.* les cinq décodeurs SOVA 322a à 322e.

Dans le cas où le nombre P d'informations décodées du premier groupe est supérieur au nombre de décodeur SOVA au moins une partie des informations décodées du premier groupe correspondent aux premières informations de chaque fenêtre de travail des décodeurs SOVA 322a à 322e.

Une partie des informations du premier groupe du bloc ainsi décodé est ensuite renvoyée directement vers les moyens de décorrélation 322 afin d'effectuer une première mise à jour partielle, notée Mise à jour SOVA 1. Cette première mise à jour partielle correspond à la mise à jour SOVA des premières informations de chaque fenêtre de travail *Fenêtre a* à *Fenêtre e.* Une autre partie d'informations comprenant le reste des informations décodées du premier groupe est renvoyée vers les moyens de mémorisation 323 qui mémorisent ces informations ainsi décodées. Ces informations seront utilisées ultérieurement dans le décodage par le décodeur LDPC 321, sans avoir été mis à jour par les moyens de décorrélation 322. Ceci, bien entendu, dans le cas où le décodeur LDPC 321 traite plus d'informations à la fois que les moyens de décorrélation 322. Les informations non mises à jour cette fois-ci par les moyens de décorrélation 322, le seront ultérieurement à la suite d'une des itérations de décodage du décodeur LDPC 321.

Une fois la première mise à jour partielle réalisée, le bloc partiellement mis à jour par les moyens de décorrélation 322, comprenant la première information de chaque fenêtre de travail ainsi mise à jour, est délivrée au décodeur LDPC 321 via les moyens de mémorisation 323 afin d'opérer un décodage d'un second groupe de P informations.

Dans l'exemple illustré, les cinq informations du second groupe décodées par le décodeur LDPC 321 correspondent à la seconde information de chacune des cinq fenêtres de travail *Fenêtre a* à *Fenêtre e* des cinq décodeurs SOVA 322a à 322e.

Si le premier groupe de P informations ne comprenait pas les secondes informations de chaque fenêtre de travail, alors au moins une partie des informations du second groupe correspond aux secondes informations de chaque fenêtre de travail des décodeurs SOVA 322a à 322e.

Les décodeurs SOVA travaillent de manière linéaire et traitent successivement les informations dans l'ordre où elles sont disposées dans leur fenêtre de travail. Pour optimiser le traitement des informations par le décodeur 32, les informations de chaque fenêtre de travail sont donc décodées par le décodeur LDPC 321 avant d'être décorrélées par les décodeurs SOVA 322a à 322e. C'est pourquoi il est avantageux de réaliser un décodage des informations par le décodeur LDPC 321 dans l'ordre où les informations sont traitées par les moyens de décorrélation 322.

Pour cela, les N informations du bloc ont été initialement triées par les moyens d'entrelacement 23 de la chaîne de transmission 20 de manière à ce que la première information de chaque fenêtre de traitement des moyens de décorrélation 322 soit comprise dans le premier groupe de P informations traité par le décodeur LDPC 321.

Si le groupe de P informations comprend plus d'informations que les moyens de décorrélation 322 ne comprennent de décodeurs SOVA, la seconde information de chaque fenêtre de traitement peut déjà être comprise dans le premier groupe de P informations. Dans ce cas, la seconde information de chaque fenêtre de travail sera mise à jour par les moyens de décorrélation 322 lors de la seconde mise à jour SOVA, notée Mise à jour SOVA 2. Avant la seconde mise à jour LDPC, le décodeur LDPC 321 aurait traité un groupe de P informations correspondant aux informations suivantes de chaque fenêtre de travail non comprises dans le premier groupe de P informations. Ainsi, si le premier groupe de P informations comprend la première et seconde informations de chaque fenêtre de travail, le second groupe de P informations traité par le décodeur LDPC comprendra la troisième et quatrième information de chaque fenêtre de travail.

Sur la figure 5, il faut donc bien considérer que les N informations ne sont pas organisées de la même façon lors d'une mise à jour partielle SOVA et lors d'une mise à jour LDPC.

Les informations sont ainsi successivement décodées à l'aide du décodeur LDPC 321 et décorrélées par les décodeurs SOVA 322a à 322e. Une fois que la dernière mise à jour partielle (Mise à jour SOVA n), a été réalisée, c'est-à-dire une fois que la dernière information de chaque fenêtre de travail a été traitée par les décodeurs SOVA 322a à 322e un bouclage est réalisé afin de recommencer une nouvelle succession de mises à jour partielles des informations par les moyens de décorrélation 322 et les moyens de décodage 321.

Il est à noter que si les groupes de P informations comprennent plus d'informations que les moyens de décorrélation 322 ne peuvent mettre d'informations à jour, c'est-à-dire si le nombre P d'informations est supérieur au nombre de décodeurs SOVA compris dans les moyens de décorrélation 322, le décodeur LDPC 321 réalise plusieurs décodages des groupes de P informations constituant le bloc de N informations pendant que les moyens de décorrélation 322 réalisent une mise à jour des N informations du bloc.

La figure 6 illustre l'évolution du taux d'erreurs de secteur (Sector Failure Rate, SFR) en fonction du rapport signal sur bruit.(Signal-to-Noise Ratio, SNR).

La courbe C₀ en pointillées représente l'évolution pour un décodeur selon l'art antérieur, après une unique itération externe.

La courbe C₁ en trait plein avec des repères en croix représente l'évolution pour un décodeur selon l'art antérieur après deux itérations externes.

La courbe C₂ en trait plein avec des repères carrés représente l'évolution pour un décodeur selon l'art antérieur, après trois itérations externes.

Enfin, la courbe C₃ en trait plein sans repère représente l'évolution pour un décodeur 32, selon l'invention, comprenant des moyens de décorrélation comportant dix-neuf décodeurs SOVA montés en parallèle et des groupes de P=4x38=152 informations. Dans le cas présentés, la trame comprend N=4864 informations. Le degré de connexion des noeuds de contrôle est constant et vaut 38 pour tous les noeuds de contrôle. Dans l'exemple illustré, le décodeur 32 traite les lignes quatre par quatre, c'est-à-dire qu'il effectue la mise à jour de quatre noeuds de contrôle en un traitement. C'est pourquoi les groupes d'informations comprennent P=4x38=152 informations

On remarque d'après les courbes que le taux d'erreurs de secteur est nettement plus faible pour un décodeur 32 selon l'invention que pour un décodeur selon l'art antérieur pour un même rapport signal sur bruit. Si on regarde, par exemple, pour SNR=11,5, le taux d'erreurs de secteur est deux ordres de grandeurs plus petit pour un décodeur 32 selon l'invention qu'un décodeur selon l'art antérieur après trois itérations externes.

En considérant le graphisme d'un point de vue utilisateur, on peut voir que pour un taux d'erreurs de secteur donné, qui peut correspondre au maximum souhaité par l'utilisateur, le rapport signal sur bruit est de 0,3dB plus petit pour le décodeur 32 selon l'invention que pour le décodeur selon l'art antérieur après trois itérations externes. Ainsi le décodeur 32 selon l'invention peut traiter un signal plus bruité qu'un décodeur selon l'art antérieur sans que le taux d'erreurs de secteur ne dépasse le maximum de taux d'erreurs de secteur souhaité par l'utilisateur.

## Revendications

1. Procédé de décodage d'un bloc de N informations encodées avec un code de correction d'erreur et mutuellement corrélées, **caractérisé en ce que** :
a) on réalise une première décorrélation des N informations du bloc ;
b) on mémorise le bloc ainsi décorrélé ;
c) on effectue un traitement de décodage d'un groupe de P informations dudit bloc ;
d) on décorrèle au moins une partie des P informations décodées ;
e) on réitère les étapes c) et d) avec des groupes successifs différents de P informations dudit bloc jusqu'à traiter les N informations dudit bloc ;
f) on réitère l'étape e) jusqu'à la satisfaction d'un critère de décodage.

2. Procédé selon la revendication 1, dans lequel le code de correction d'erreur comporte des noeuds de contrôle et des noeuds d'informations reliés selon une connectivité définie, le groupe de P informations comporte des informations relatives à au moins un noeud de contrôle et aux noeuds d'information connectés à ce noeud de contrôle, et le traitement de décodage effectué à l'étape c) comporte une mise à jour dudit au moins un noeud de contrôle et des noeuds d'informations qui lui sont connectés.

3. Procédé selon l'une des revendications 1 ou 2, dans lequel dans l'étape d) on décorrèle toutes les P informations décodées du groupe.

4. Procédé selon l'une des revendications 1 à 3, dans lequel le code de correction d'erreur est un code du type LDPC.

5. Procédé selon l'une des revendications 1 à 4, dans lequel on décorrèle les informations à l'aide d'un algorithme de Viterbi de type SOVA.

6. Dispositif de décodage comprenant une entrée pour recevoir un bloc de N informations encodées avec un code de correction d'erreur et mutuellement corrélées, des moyens de décorrélation aptes à décorréler ledit bloc, des moyens de mémoire aptes à mémoriser ledit bloc, et des moyens de décodage du code de correction d'erreur aptes à décoder ledit bloc de façon itérative, **caractérisé en ce qu'**il comprend :
- des moyens de commande aptes à activer les moyens de décorrélation pour réaliser une première décorrélation des N informations du bloc, à activer les moyens de mémorisation pour mémoriser le bloc ainsi décorrélé, à activer les moyens de décodage pour effectuer un traitement de décodage d'un groupe de P informations dudit bloc, puis à activer les moyens de décorrélation pour décorréler au moins une partie des P informations décodées, et à répéter ces activations avec des groupes successifs différents de P informations dudit bloc jusqu'à traiter les N informations du bloc, et
- des moyens de gestion aptes à activer les moyens de commande jusqu'à la satisfaction d'un critère de décodage.

7. Dispositif de décodage selon la revendication 6, dans lequel le code de correction d'erreur comporte des noeuds de contrôle et des noeuds d'informations reliés selon une connectivité définie, le groupe de P informations comporte des informations relatives à au moins un noeud de contrôle et aux noeuds d'information connectés à ce noeud de contrôle, et le dispositif de décodage est apte à effectuer une mise à jour dudit au moins un noeud de contrôle et des noeuds d'informations qui lui sont connectés.

8. Dispositif de décodage selon l'une des revendications 6 ou 7, dans lequel les moyens de décorrélation comprennent une pluralité de modules de décorrélation couplés parallèlement les uns aux autres, le nombre de modules de décorrélation correspondant au plus à un nombre de P informations comprises dans un groupe d'un bloc.

9. Dispositif de décodage selon l'une des revendications 6 à 8, dans lequel les moyens de décodage du code de correction d'erreur forment des moyens de décodage de code LDPC.

10. Dispositif de décodage selon l'une des revendications 6 à 9, dans lequel les modules de décorrélation forment des moyens de décodage de canal à algorithme de Viterbi de type SOVA.

11. Récepteur (40) d'un système de communication (10) comprenant un dispositif de décodage selon l'une des revendications 6 à 10.

12. Récepteur selon la revendication 11, incorporé au sein d'une chaîne de lecture d'un disque dur.

13. Système de communication (10) comprenant un récepteur (40) selon la revendication 11 ou 12, un transmetteur (20) comprenant des moyens d'encodage (22) des informations avec un code de correction d'erreur et des moyens d'entrelacement (23) des informations, et un canal de transmission (3).

14. Système de communication (10) selon la revendication 13, **caractérisé en ce qu'**il est un système d'enregistrement magnétique tel qu'un disque dur.
